# EUROPEAN PATENT APPLICATION

(11) **EP 4 383 350 A1**
(43) Date of publication of application: **12.06.2024**
(21) Application number: 23844159.6
(22) Date of filing: 24.08.2023
(51) Int. Cl.: H01L 31/0216, H01L 31/18

(54) **SOLAR CELL, AND MANUFACTURING METHOD THEREFOR**

(30) Priority: 27.10.2022 CN 202211326548
(71) Applicant: Tongwei Solar (Meishan) Co., Ltd., Meishan, Sichuan 620041 (CN)
(72) Inventor: XU, Wenzhou, Meishan, Sichuan 620041 (CN); XING, Guoqiang, Meishan, Sichuan 620041 (CN)
(74) Representative: Marks & Clerk LLP
(86) International application number: PCT/CN2023/114589
(87) International publication number: WO 2024/087838

(57) **Abstract**

Embodiments of the present application provide a solar cell and a preparation method thereof, which relates to the field of photovoltaic cell preparation. The solar cell includes: an N-type silicon wafer, where a front surface of the N-type silicon wafer is provided with a doped region containing boron, the doped region is divided into a lightly doped region and a heavily doped region, a boron concentration of the lightly doped region is less than a boron concentration of the heavily doped region, a junction depth of the lightly doped region is less than a junction depth of the heavily doped region; a passivation layer and a first anti-reflection layer that are sequentially stacked on the front surface of the N-type silicon wafer. An area of a surface of the first anti-reflection layer corresponding to the heavily doped region is provided with an electrode. The electrode extends through the first anti-reflection layer and the passivation layer, and is in an ohmic contact with the heavily doped region. The solar cell of the present application can well reduce the contact resistance between the N-type silicon wafer and the electrode, thereby improving cell efficiency.

## Description

### CROSS-REFERENCE TO RELATED APPLICATIONS

This application claims priority to China Patent Application No. 202211326548.6, entitled "solar cell and preparation method thereof, filed on October 27, 2022, the content of which is hereby incorporated by reference in its entirety.

### TECHNICAL FIELD

The present application relates to the field of photovoltaic cell preparation, and in particular, to a solar cell and a preparation method thereof.

### BACKGROUND

Solar cells (also known as "solar batteries") can convert light energy into electrical energy, which can save energy and reduce emissions. Solar cells can be divided into several categories, such as Tunnel Oxide Passivated Contact solar cells (TOPCon cells), which generally use N-type silicon wafers as substrates. Good interface passivation layers are provided on a front surface and a back surface of the N-type silicon wafer, respectively. In addition, an electrode in a good electrical connection with the N-type silicon wafer is also provided on a surface of the passivation layer.

A conventional TOPCon cell has high square resistance, which can effectively reduce the occurrence of Auger recombination and increase the opening voltage and current of the cell. However, due to the high square resistance, the contact resistance between the electrode and the N-type silicon wafer is also very large, which can affect the fill factors of the cell and is disadvantageous to improving the photoelectric conversion efficiency of the cell.

### SUMMARY

An object of the embodiments of the present application is to provide a solar cell and a preparation method thereof. The solar cell can well reduce a contact resistance between an electrode and a N-type silicon wafer, thereby improving the cell efficiency.

In a first aspect, embodiments of the present application provide a solar cell, which includes: an N-type silicon wafer, where a front surface of the N-type silicon wafer is provided with a doped region containing boron, the doped region is divided into a lightly doped region and a heavily doped region, a boron concentration of the lightly doped region is less than a boron concentration of the heavily doped region, a junction depth of the lightly doped region is less than a junction depth of the heavily doped region; a passivation layer and a first anti-reflection layer that are sequentially stacked on the front surface of the N-type silicon wafer. An area of a surface of the first anti-reflection layer corresponding to the heavily doped region is provided with an electrode. The electrode extends through the first anti-reflection layer and the passivation layer, and is in an ohmic contact with the heavily doped region.

In the above technical solution, the doped region contains boron, and thus a PN junction is formed between the doped region and other areas of the N-type silicon wafer. After being irradiated by sunlight, the PN junction can generate carriers, and the electrode in an ohmic contact with doped region can collect carriers in the doped region, thereby outputting current to the outside. The doped area is divided into the heavily doped region and the lightly doped region. The electrode is located in the heavily doped region; the boron concentration of the heavily doped region is greater than that of the lightly doped region, and the junction depth of the heavily doped region is greater than that of the lightly doped region, which is beneficial to reduce the contact resistance between the N-type silicon wafer and the electrode, which can improve cell efficiency.

The passivation layer can protect the N-type silicon wafer and the doped area on the surface of the N-type silicon wafer, ensuring that the front surface of the N-type silicon wafer and the doped area are not easily oxidized. The first anti-reflection layer can reduce the light reflectivity of the solar cell, thereby improving the light absorption efficiency of solar cells and helping to improving cell efficiency.

In a possible implementation, the boron concentration of the lightly doped region is in a range from 10¹⁸ cm⁻³ to 10¹⁹ cm⁻³, and the boron concentration of the heavily doped region is in a range from 10¹⁹ cm⁻³ to 10²⁰ cm⁻³.

In a possible implementation, the junction depth of the lightly doped region is in a range from 0.4 µm to 0.8 µm; and the junction depth of the heavily doped region is in a range from 1.0 µm to 1.4 µm.

In a possible implementation, a polysilicon layer and a second anti-reflection layer are sequentially stacked on a back surface of the N-type silicon wafer.

In the above technical solutions, the polysilicon layer on the back surface of the N-type silicon wafer has a good passivation effect and can reduce the metal contact recombination current. The second anti-reflection layer can not only reduce the light reflectivity of the solar cell, but also protect the back surface of the N-type silicon wafer from being not easily oxidized.

In a second aspect, embodiments of the present application provide a preparation method of the solar cell according to the first aspect, which includes the following steps: using a gas phase boron source to perform a first boron diffusion on the front surface of the N-type silicon wafer, to form the lightly doped region and a borosilicate glass layer with a thickness of no more than 10 nm on the front surface of the N-type silicon wafer; then, coating a boron paste onto a surface of the borosilicate glass layer, and performing a second boron diffusion using the boron paste to form the heavily doped region; and then, removing the borosilicate glass layer, forming the passivation layer and the first anti-reflection layer sequentially on the front surface of the N-type silicon wafer, and printing the electrode on the area of the surface of the first anti-reflection layer corresponding to the heavily doped region, and enabling the electrode to extend through the first anti-reflection layer and the passivation layer, and be in an ohmic contact with the heavily doped region.

In the existing preparation method, during the process of boron diffusion to form the lightly doped region, a BSG (Borosilicate glass) layer can inevitably be formed. The BSG layer can protect the PN junction formed by the lightly doped region and the N-type silicon wafer from not being oxidized. However, the BSG layer can also make it difficult to form the heavily doped region in the future, which is why it is difficult to reduce the contact resistance between the electrode and the N-type silicon wafer.

In the above technical solutions, the applicant found that if in the process of forming the lightly doped region (that is, in the first boron diffusion process), the thickness of the BSG layer is controlled to be no more than 10 nm, and then the boron paste is coated ono the surface of the BSG layer with the thickness of no more than 10 nm, and then, the second boron diffusion is performed, so that the heavily doped region can be effectively formed on the surface of the N-type silicon wafer. The formed BSG layer can still protect the PN junction and ensure that the PN junction is not easily oxidized. Moreover, in the first boron diffusion process, using the gas phase boron source is beneficial to forming the BSG layer with a thickness of no more than 10 nm. In the second boron diffusion process, using the boron paste is beneficial to forming the heavily doped region.

In a possible implementation, in the step of the first boron diffusion, a temperature is in range from 850°C to 1000°C.

In a possible implementation, in the step of the first boron diffusion, the gas phase boron source is at least one of BCl₃, BBrs, and BHs.

In a possible implementation, in the step of the second boron diffusion, oxygen is introduced at 700°C to 800°C for 30 min to 60 min, to remove impurities in the boron paste, and then the oxygen is stopped from being introduced, and a treatment is performed at 900°C to 1100°C for 10 min to 60 min under anaerobic condition.

In a possible implementation, the passivation layer or the first anti-reflection layer is formed using a vapor deposition.

In the above technical solutions, the thicknesses of the passivation layer and the first anti-reflection layer can be accurately controlled by using vapor deposition.

In a possible implementation, after forming the heavily doped region, the following step is further included: forming a polysilicon layer and a second anti-reflection layer sequentially on a back surface of the N-type silicon wafer.

### BRIEF DESCRIPTION OF THE DRAWINGS

In order to more clearly illustrate the technical solutions of the embodiments of the present application, the drawings required to be used in the embodiments of the present application will be briefly introduced below. It should be understood that the following drawings only show some embodiments of the present application, which therefore should not be regarded as limiting the scope. For those of ordinary skill in the art, other relevant drawings can be obtained based on these drawings without exerting creative efforts.

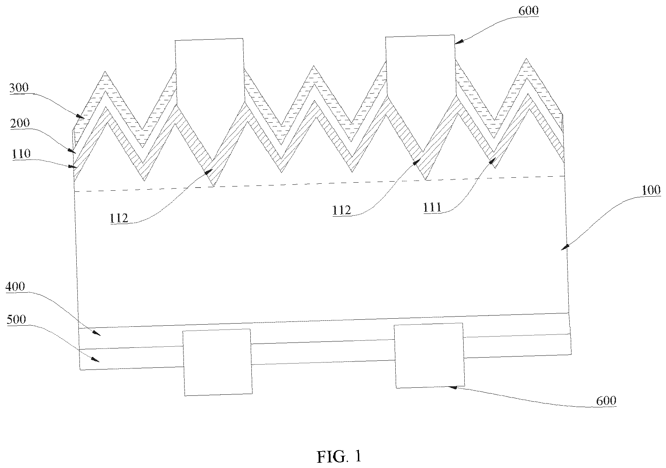

FIG. 1 is a schematic view of a solar cell according to an embodiment of the present application.

Reference numerals: 001-solar cell; 100-N-type silicon wafer; 110-doped area; 111-lightly doped region; 112-heavily doped region; 200-passivation layer; 300-first anti-reflection layer; 400- Polysilicon layer; 500-second anti-reflection layer; 600-electrode.

### DETAILED DESCRIPTION OF THE EMBODIMENTS

In order to make the object, technical solutions, and advantages of the embodiments of the present application clearer, the technical solutions in the embodiments of the present application will be clearly and completely described below. If the specific conditions are not specified in the examples, the conventional conditions or the conditions recommended by the manufacturer should be followed. If the manufacturers of the reagents or instruments used are not indicated, the reagents or instruments are all conventional products available commercially.

A solar cell 001 and a preparation method thereof according to an embodiment of the present application will be described in detail below.

Referring to FIG. 1, The solar cell 001 according to this embodiment has the following structures.

The structure of the solar cell 001 according to the embodiment of the present application uses an N-type silicon wafer 100 as a substrate. A doped region 110 containing boron is provided on a front surface of the N-type silicon wafer 100. The doped region 110 is P-type, and can form a PN junction with other regions of N-type silicon wafer 100. The PN junction can generate carriers after being irradiated by sunlight, so as to subsequently output current to the outside. The doped region 110 is divided into a lightly doped region 111 and a heavily doped region 112, and a boron concentration of the lightly doped region 111 is less than a boron concentration of the heavily doped region 112.

A passivation layer 200 and a first anti-reflection layer 300 are sequentially stacked on the front surface of the N-type silicon wafer 100. The passivation layer 200 can protect the N-type silicon wafer 100 and the doped region 110 on the surface of the N-type silicon wafer 100, ensuring that the front surface of the N-type silicon wafer 100 and the doped region 110 are not easily oxidized. The passivation layer 200 can be made of aluminum oxide (AlOₓ), silicon oxide and other oxides. As an example, the passivation layer 200 in this embodiment is aluminum oxide. The first anti-reflection layer 300 can reduce the light reflectivity of the solar cell 001, thereby improving the light absorption efficiency of the solar cell 001, which is beneficial to improving the cell efficiency. As an example, the first anti-reflection layer 300 in this embodiment is made of silicon nitride (SiNₓ).

An electrode 600 is provided on an area of the surface of the first anti-reflection layer 300 corresponding to the heavily doped region 112. The electrode 600 is usually made of silver. Since the first anti-reflection layer 300 and the passivation layer 200 are not electrically conductive, the electrode 600 extends through the first anti-reflection layer 300 and the passivation layer 200, and is in an ohmic contact with the heavily doped region 112, so that the electrode 600 can collect carriers generated by the PN junction. The boron concentration of the lightly doped region 111 is less than that of the heavily doped region 112, and the junction depth is also less than the concentration of the heavily doped region 112. Therefore, when the heavily doped region 112 is in an ohmic contact with the electrode 600, the contact resistance can be significantly reduced, which can help improve cell efficiency and not significantly increase the occurrence of Auger recombination. As an example, in this embodiment, the boron concentration of the lightly doped region 111 is in a range from 10¹⁸ cm⁻³ to 10¹⁹ cm⁻³, and the junction depth is in a range from 0.4 µm to 0.8 µm; the boron concentration of the heavily doped region 112 is in a range from 10¹⁹ cm⁻³ to 10²⁰ cm⁻³, and the junction depth is in a range from 1.0 µm to 1.4 µm.

A polysilicon layer 400 and a second anti-reflection layer 500 are sequentially stacked on a back surface of the N-type silicon wafer 100. The polysilicon layer 400 has a good passivation effect and can reduce metal contact recombination current. The second anti-reflection layer 500 can not only reduce the light reflectivity of the solar cell 001, but also protect the back surface of the N-type silicon wafer 100 from oxidation. As an example, the second anti-reflection layer 500 in this embodiment is made of the same material as the first anti-reflection layer 300, which is silicon nitride. In addition, in this embodiment, an electrode 600 is also provided on the surface of the second anti-reflection layer 500, and is also made of silver. The electrode 600 on the surface of the second anti-reflection layer 500 can extend through the second anti-reflection layer 500 to be in contact with the polysilicon layer 400, and use the quantum tunneling effect to collect carriers generated by the PN junction.

The above-mentioned cell is generally called a tunnel oxide passivated contact solar cell (TOPcon). Currently, when preparing this type of cell, a boron source is directly used to diffuse boron on the front surface of the N-type silicon wafer 100 to form the doped region 110. A thick BSG layer can be inevitably be formed. Although the BSG layer can protect the doped region 110 from being oxidized, the BSG layer can prevent further diffusion of boron, preventing the formation of lightly doped regions 111 and heavily doped regions 112 with different boron concentrations.

Therefore, this application further provides a preparation method of the above-mentioned solar cell 001, which has specific steps as follows.

At S100, a texturing is performed.

An N-type silicon wafer 100 is prepared. Alkali solution is used to texturize the front and back surfaces of the N-type silicon wafer 100, so that a pyramid-shaped texture is formed on the surface of the N-type silicon wafer 100, which is beneficial to increasing the light absorption of the N-type silicon wafer 100. The alkali solution used in texturing is usually KOH or NaOH solution, a concentration of which is generally 1%. After texturing is completed, the silicon wafer is cleaned using hydrogen peroxide and alkali solution.

At S200, a first boron diffusion is performed.

A gas phase boron source is used to perform the first boron diffusion on the front surface of the N-type silicon wafer 100, so as to form a lightly doped region 111 and a borosilicate glass (BSG) layer with a thickness of no more than 10 nm on the front surface of the N-type silicon wafer 100. The BSG layer with a thickness of no more than 10 nm can not only protect the lightly doped region 111 to ensure that the lightly doped region 111 is not oxidized during the production process, and the subsequent second boron diffusion is also not hindered, which can ensure that the subsequent formation of the heavily doped region 112 on the front surface of the N-type silicon wafer 100.

As an example, the gas phase boron source in this step can be at least one of BCl₃, BBrs, and BHs, and the processing temperature in this step is generally in a range from 850°C to 1000°C, and the time is generally in a range from 10 min to 60 min.

At S300, a second boron diffusion is performed.

This step is to coat the boron paste onto the surface of the BSG layer and perform the second boron diffusion. The use of boron paste facilitates the boron element to pass through the BSG layer and penetrate into the front surface of the N-type silicon wafer 100, thereby forming the heavily doped region 112. During the second boron diffusion process, the thickness of the BSG layer can be increased to more than 100 nm, which can prevent subsequent cleaning (see subsequent description for cleaning process) from causing over-etching of the front surface during wrap-around plating.

Specifically, in this step, the paste is dried at a temperature in a range from 150°C to 300°C, and the drying time generally lasts for 30s to 90s. Thereafter, oxygen is introduced for treatment at 700°C to 800°C for 30 min to 60 min. In this way, impurities such as carbon in the boron paste can be removed and converted into carbon dioxide and be discharged, solving the problem of residual impurities. Then, introducing of oxygen is stopped, and a treatment is performed at 900°C to 1100°C for 10 min to 60 min under anaerobic condition, which helps the boron paste to diffuse and form the junction better, and form a deeper junction depth.

At S400, a back surface of the N-type silicon wafer 100 is cleaned.

While the boron is diffused on the front surface of the N-type silicon wafer 100, not only the BSG layer is formed on the front surface, but also the BSG layer and the doped region 110 are formed on the back surface. The BSG layer is an unnecessary layer structure for the subsequent formation of solar cell 001, and therefore needs to be removed. In this step, a chain HF machine is generally used to remove the BSG layer formed on the back surface through wrap-around plating due to boron diffusion, and then a trough-type alkali polishing machine is used to remove pn junctions on the back surface and on the edge.

At S500, a polysilicon layer 400 is formed.

In this step, vapor deposition is generally used to deposit an amorphous silicon film on the back surface of the N-type silicon wafer 100, and then the amorphous silicon film is transformed into the polysilicon layer 400 by annealing under a nitrogen or oxygen atmosphere.

The use of vapor deposition is beneficial to controlling the thickness of the film. Vapor deposition methods include plasma enhanced atomic layer deposition (PEALD) and plasma enhanced chemical vapor deposition (PECVD), etc. As an example, in this embodiment, the amorphous silicon film is deposited by PECVD.

At S600, the front surface of the N-type silicon wafer 100 is cleaned.

As in step S400, the BSG layer is an unnecessary layer structure for subsequent formation of the solar cell 001, and therefore needs to be removed. This step is to remove the BSG layer from the front surface of the N-type silicon wafer 100. Specifically, firstly, the RCA standard cleaning method is used for cleaning (the RCA standard cleaning method is a commonly used technology and will not be repeated herein in this application); then, the chain HF machine is used to remove the BSG layer on the front surface, and then the trough-type alkali polishing machine is used to remove the boron paste residue from printing on the front surface.

The BSG layer is removed only in this step to prevent contamination of the doped layer during the preparation process.

At S700, a passivation layer 200 and a first anti-reflection layer 300 are formed.

In this step, the vapor deposition is also generally used to deposit the passivation layer 200 and the first anti-reflection layer 300, respectively. The passivation layer 200 is generally made of aluminum oxide, and the first anti-reflection layer 300 is made of silicon nitride.

At S800, a second anti-reflection layer 500 is formed.

In this step, the vapor deposition is also generally used to deposit the passivation layer 200 and the first anti-reflection layer 300, respectively. Moreover, in this embodiment, the second anti-reflection layer 500 and the first anti-reflection layer 300 are made of the same material, which is silicon nitride.

At S900, an electrode 600 is formed.

In this step, silver paste is generally screen printed on the surfaces of the first anti-reflection layer 300 and the second anti-reflection layer 500, followed by drying and sintering to form the electrode 600. The electrode 600 on the surface of the first anti-reflection layer 300 is located in the area where the heavily doped region 112 is located. The electrode 600 on the surface of the first anti-reflection layer 300 extends through the first anti-reflection layer 300 and the passivation layer 200, and is in an ohmic contact with the heavily doped region 112.

The features and performance of the present application will be described in further detail below in conjunction with examples.

### Example 1

This example provides a solar cell 001, the preparation process of which includes the following steps:
(1) Texturing. a N-type silicon wafer 100 was used. 1% NaOH solution was used to texturize the N-type silicon wafer 100, and then hydrogen peroxide and alkali solution were used to clean the textured N-type silicon wafer 100.
(2) First boron diffusion. BCl₃ was used as a boron source. The first boron diffusion was performed on the front surface of the N-type silicon wafer 100 in a tubular boron diffusion furnace, with a processing temperature of 950°C and the processing time of 1800s, to form a lightly doped region 111 and a BSG layer of 5nm.
(3) Second boron diffusion. A screen printer was used to print a boron paste with a concentration of 7% and a finger line height of 2 µm, on a surface of the BSG layer. The boron paste was dried at 200°C for 60 seconds. Then, at 800°C, oxygen was introduced for 30 min to remove the carbon in the organic matter. Then, the temperature was raised to 1000°C under anaerobic condition and maintained for 1800s for anaerobic diffusion and junction formation. Then, a heavily doped region 112 was formed on the front surface of the N-type silicon wafer 100, and the BSG layer of 120 nm was formed on the front surface of the silicon wafer.
(4) Cleaning a back surface of the N-type silicon wafer 100. A chain HF machine was used to remove the BSG formed on the back surface through wrap-around plating due to boron diffusion, and then a trough-type alkali polishing machine was used to remove the p-n junctions the back surface and on the edge.
(5) Formation of a polysilicon layer 400. A tubular PECVD equipment was used to deposit an amorphous silicon film on the back surface of the silicon wafer, then a tube furnace was used to anneal, and nitrogen was used to convert the deposited amorphous silicon film into the polysilicon layer 400.
(6) Cleaning the front surface of the N-type silicon wafer 100. An RCA marking cleaning method was used to clean the front surface of the N-type silicon wafer 100, then a chain HF machine was used to remove the BSG layer on the front surface, and then a trough-type alkali polishing machine was used to remove the boron paste residue from printing on the front surface.
(7) Formation of a passivation layer 200 and a first anti-reflection layer 300. An oxide layer was firstly deposited on the front surface of the N-type silicon wafer 100 as the passivation layer 200 using PECVD, and then a silicon nitride layer was deposited on the surface of the passivation layer 200 as the first antireflection layer 300.
(8) Formation of a second anti-reflection layer 500. Silicon nitride was deposited using PECVD, and a silicon nitride layer was deposited on the surface of the polysilicon layer 400 as the second anti-reflection layer 500.
(9) Formation of an electrode 600. Silver paste was printed on the surfaces of the first anti-reflection layer 300 and the second anti-reflection layer 500 by screen printing, and followed by drying and sintering to form the electrode 600. The electrode 600 on the surface of the first anti-reflection layer 300 is located in the area where the heavily doped region 112 is located, and extends through the first anti-reflection layer 300 and the passivation layer 200, and is in an ohmic contact with the heavily doped region 112. The electrode 600 on the surface of the second anti-reflection layer 500 extends through the second anti-reflection layer 500 and is in an electrical contact with the polysilicon layer 400.

### Example 2

This example provides a solar cell 001. This example mainly differs from the preparation process of Example 1 in that:
In step (3), oxygen was introduced at 700°C for 30 min to remove carbon from the organic matter.

### Example 3

This example provides a solar cell 001. This example mainly differs from the preparation process of Example 1 in that:
In step (3), the temperature was raised to 980°C under reduced pressure (700pa) for anaerobic diffusion and junction formation, a heavily doped region 112 was formed on the front surface of the N-type silicon wafer 100, and a BSG layer of 120 nm was formed on the front surface of the silicon wafer.

### Example 4

This example provides a solar cell 001. This example mainly differs from the preparation process of Example 1 in that:
In step (3), anaerobic diffusion and junction formation was performed under normal pressure and anaerobic conditions at 1040°C, a heavily doped region 112 was formed on the front surface of the N-type silicon wafer 100, and a BSG layer of 120 nm was formed on the front surface of the silicon wafer.

### Example 5

This example provides a solar cell 001. This example mainly differs from the preparation process of Example 1 in that:
In step (3), 1000 sccm of oxygen was introduced to form a BSG layer of 150 nm on the front surface of the N-type silicon wafer 100.

### Example 6

This example provides a solar cell 001. This example mainly differs from the preparation process of Example 1 in that:
In step (2), BBrs was used as a boron source, with a processing temperature of 950°C, and a processing time of 2400 s, to form a lightly doped region 111 and a BSG layer of 9 nm.

### Comparative Example 1

This comparative example provides a solar cell 001. This comparative example mainly differs from the preparation process of Example 1 in that:
In step (2), boron paste was used as a boron source, with a processing temperature of 950°C, and a processing time of 2400 s, to form a doped region 110 and a BSG layer of 20 nm.

### Comparative Example 2

This comparative example provides a solar cell 001. This comparative example mainly differs from the preparation process of Example 1 in that:
In step (2), a processing temperature was 980°C, a processing time was 3600s, to form a doped region 110 and a BSG layer of 30 nm.

### Comparative Example 3

This comparative example provides a solar cell 001. This comparative example mainly differs from the preparation process of Example 1 in that:
Step (3) is omitted, and in step (9), the electrode 600 on the surface of the first anti-reflection layer 300 extends through the first anti-reflection layer 300 and the passivation layer 200, to be in an ohmic contact with the lightly doped region 111.

### Application Examples

Performances of solar cells 001 of Examples 1 to 6 and Comparative Examples 1 to 3 were tested using a Halm testing machine. The specific results are as shown in the table below.

**Table 1 Performances of solar cells of Examples 1 to 6 and Comparative Examples 1 to 3**

| Group | Conversion efficiency (%) | Open circuit voltage (V) | Short circuit current (mA/cm²) | Fill factor (%) |
|---|---|---|---|---|
| Example 1 | 24.91 | 0.7134 | 13.89 | 83.02 |
| Example 2 | 24.90 | 0.7130 | 13.89 | 83.03 |
| Example 3 | 24.87 | 0.7115 | 13.90 | 83.04 |
| Example 4 | 24.95 | 0.7139 | 13.88 | 83.15 |
| Example 5 | 24.93 | 0.7134 | 13.90 | 83.03 |
| Example 6 | 24.91 | 0.7132 | 13.89 | 83.04 |
| Comparative Example 1 | 24.65 | 0.7087 | 13.85 | 82.93 |
| Comparative Example 2 | 24.86 | 0.7098 | 13.92 | 83.09 |
| Comparative Example 3 | 24.82 | 0.7096 | 13.91 | 83.03 |

The above description illustrates only examples of the present application, and are not intended to limit the scope of protection of the present application. For those skilled in the art, various modifications and variants may be made to the present application. Any modifications, equivalent replacements, improvements, etc. made within the spirit and principles of this application shall be included in the protection scope of this application.

## Claims

1. A solar cell, comprising:
an N-type silicon wafer, wherein a front surface of the N-type silicon wafer is provided with a doped region containing boron; the doped region is divided into a lightly doped region and a heavily doped region; a boron concentration of the lightly doped region is less than a boron concentration of the heavily doped region; a junction depth of the lightly doped region is less than a junction depth of the heavily doped region; and
a passivation layer and a first anti-reflection layer that are sequentially stacked on the front surface of the N-type silicon wafer; wherein an area of a surface of the first anti-reflection layer corresponding to the heavily doped region is provided with an electrode; the electrode extends through the first anti-reflection layer and the passivation layer, and is in an ohmic contact with the heavily doped region.

2. The solar cell according to claim 1, wherein the boron concentration of the lightly doped region is in a range from 10¹⁸ cm⁻³ to 10¹⁹ cm⁻³, and the boron concentration of the heavily doped region is in a range from 10¹⁹ cm⁻³ to 10²⁰ cm⁻³.

3. The solar cell according to any one of claims 1 to 2, wherein the junction depth of the lightly doped region is in a range from 0.4 µm to 0.8 µm; and the junction depth of the heavily doped region is in a range from 1.0 µm to 1.4 µm.

4. The solar cell according to any one of claims 1 to 3, wherein a polysilicon layer and a second anti-reflection layer are sequentially stacked on a back surface of the N-type silicon wafer.

5. A preparation method of the solar cell according to any one of claims 1 to 4, comprising the following steps:
using a gas phase boron source to perform a first boron diffusion on the front surface of the N-type silicon wafer, to form the lightly doped region and a borosilicate glass layer with a thickness of no more than 10 nm on the front surface of the N-type silicon wafer;
coating a boron paste onto a surface of the borosilicate glass layer, and performing a second boron diffusion using the boron paste to form the heavily doped region; and
removing the borosilicate glass layer, forming the passivation layer and the first anti-reflection layer sequentially on the front surface of the N-type silicon wafer, and printing the electrode on the area of the surface of the first anti-reflection layer corresponding to the heavily doped region, and enabling the electrode to extend through the first anti-reflection layer and the passivation layer, and be in an ohmic contact with the heavily doped region.

6. The preparation method of the solar cell according to claim 5, wherein in the step of the first boron diffusion, a temperature is in range from 850°C to 1000°C.

7. The preparation method of the solar cell according to any one of claims 5 to 6, wherein in the step of the first boron diffusion, the gas phase boron source is at least one of BCl₃, BBrs, and BH₃.

8. The preparation method of the solar cell according to any one of claims 5 to 7, wherein in the step of the second boron diffusion, oxygen is introduced at 700°C to to800°C for 30 min to 60 min to remove impurities in the boron paste, and then the oxygen is stopped from being introduced, and a treatment is performed at 900°C to 1100°C for 10 min to 60 min under anaerobic condition.

9. The preparation method of the solar cell according to any one of claims 5 to 8, wherein the passivation layer or the first anti-reflection layer is formed using a vapor deposition.

10. The preparation method of the solar cell according to any one of claims 5 to 9, wherein after forming the heavily doped region, the method further comprises the following step:
forming a polysilicon layer and a second anti-reflection layer sequentially on a back surface of the N-type silicon wafer.
